# EUROPEAN PATENT APPLICATION

(11) **EP 3 131 123 A1**
(43) Date of publication of application: **15.02.2017**
(21) Application number: 16183681.2
(22) Date of filing: 11.08.2016
(51) Int. Cl.: H01L 31/068, H01L 31/18

(54) **SOLAR CELL AND METHOD FOR MANUFACTURING THE SAME**

(30) Priority: 12.08.2015 KR 20150113607
(71) Applicant: LG ELECTRONICS INC., Yeongdeungpo-gu Seoul 07336 (KR)
(72) Inventor: YI, Mann, 08592 Seoul (KR); LEE, Daeyong, 08592 Seoul (KR); KIM, Jeongkyu, 08592 Seoul (KR); AHN, Junyong, 08592 Seoul (KR)
(74) Representative: Frenkel, Matthias Alexander

(57) **Abstract**

A solar cell and a method for manufacturing the same are disclosed. The method for manufacturing the solar cell includes injecting impurities of a second conductive type opposite a first conductive type into an entire first surface of a semiconductor substrate containing impurities of the first conductive type, the semiconductor substrate having the first surface, a side surface, and a second surface opposite the first surface, forming a doping barrier layer on the entire first surface and the entire side surface of the semiconductor substrate, and at an edge portion of the second surface of the semiconductor substrate, injecting the impurities of the first conductive type into the second surface of the semiconductor substrate at which the doping barrier layer is not formed, at a higher concentration than the semiconductor substrate, performing a thermal process on the semiconductor substrate to simultaneously form an emitter region of the second conductive type at the entire first and side surfaces of the semiconductor substrate and a back surface field region of the first conductive type at the second surface of the semiconductor substrate, and removing the doping barrier layer.

## Description

### CROSS-REFERENCE TO RELATED APPLICATIONS

This application claims priority to and the benefit of Korean Patent Application No. 10-2015-0113607 filed in the Korean Intellectual Property Office on August 12, 2015, the entire content of which is incorporated herein by reference.

### BACKGROUND OF THE INVENTION

### Field of the Invention

Embodiments of the invention relate to a solar cell and a method for manufacturing the same.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts, which respectively have different conductive types, for example, a p-type and an n-type and thus form a p-n junction, and electrodes respectively connected to the semiconductor parts of the different conductive types.

When light is incident on the solar cell, a plurality of electron-hole pairs are produced in the semiconductor parts and are separated into electrons and holes by the incident light. The electrons move to the n-type semiconductor part, and the holes move to the p-type semiconductor part. Then, the electrons and the holes are collected by the different electrodes respectively connected to the n-type semiconductor part and the p-type semiconductor part. The electrodes are connected to each other using electric wires to thereby obtain electric power.

In a process for forming an emitter region and a back surface field region of different conductive types in a method for manufacturing the above-described solar cell, when the emitter region and the back surface field region contact each other at an edge of a semiconductor substrate, a reverse current is generated by a recombination and/or a disappearance of carriers collected at the emitter region and carriers collected at the back surface field region.

In order to prevent the reverse current, an edge isolation process for cutting off a connection between the emitter region and the back surface field region may be additionally performed in the method for manufacturing the above-described solar cell. In this instance, an edge isolated portion of the semiconductor substrate is damaged, and efficiency of the solar cell is reduced.

### SUMMARY OF THE INVENTION

Embodiments of the invention provide a solar cell having improved efficiency and a method for manufacturing the same.

In one aspect, there is provided a method for manufacturing a solar cell including injecting impurities of a second conductive type opposite a first conductive type into an entire first surface of a semiconductor substrate containing impurities of the first conductive type, the semiconductor substrate having the first surface, a side surface, and a second surface opposite the first surface, forming a doping barrier layer on the entire first surface and the entire side surface of the semiconductor substrate, and at an edge portion of the opposite surface of the semiconductor substrate, injecting the impurities of the first conductive type into a portion of the second surface of the semiconductor substrate at which the doping barrier layer is not formed, at a higher concentration than the semiconductor substrate, performing a thermal process on the semiconductor substrate to simultaneously form an emitter region of the second conductive type at the entire first and side surfaces of the semiconductor substrate and a back surface field region of the first conductive type at the second surface of the semiconductor substrate, and removing the doping barrier layer.

The impurities of the first conductive type and the impurities of the second conductive type injected into the semiconductor substrate may be simultaneously activated through the thermal process. Hence, the method for manufacturing the solar cell can be further simplified.

The injecting of the impurities of the second conductive type may include injecting the impurities of the second conductive type into the side surface of the semiconductor substrate reaching the edge portion of the second surface of the semiconductor substrate.

In the injecting of the impurities of the second conductive type, a depth of the impurities of the second conductive type injected into the side surface of the semiconductor substrate may be less than a depth of the impurities of the second conductive type injected into the first surface of the semiconductor substrate.

In the forming of the doping barrier layer, the doping barrier layer formed at the edge portion of the second surface of the semiconductor substrate may cover the edge portion of the second surface of the semiconductor substrate, to cover the impurities of the second conductive type injected into the side surface of the semiconductor substrate.

A width of the doping barrier layer formed at the edge portion of the second surface of the semiconductor substrate may be greater than a width of the impurities of the second conductive type exposed in the edge portion of the second surface of the semiconductor substrate.

The doping barrier layer may not be doped with the impurities of the first conductive type and the impurities of the second conductive type. For example, the doping barrier layer is formed of silicate glass containing silica (SiO₂).

The injecting of the impurities of the first conductive type may include injecting the impurities of the first conductive type into the entire portion of the semiconductor substrate except the edge portion of the second surface of the semiconductor substrate. In this instance, the injecting of the impurities of the first conductive type may include injecting the impurities of the first conductive type while being separated from the edge portion of the second surface of the semiconductor substrate including the impurities of the second conductive type are exposed.

The performing of the thermal process may include forming the emitter region and the back surface field region while the impurities of the first conductive type and the impurities of the second conductive type are separated from each other at the edge portion of the second surface of the semiconductor substrate. Hence, a reverse current can be prevented.

In another aspect, there is provided a solar cell including a semiconductor substrate containing impurities of a first conductive type, the semiconductor substrate having a first surface, a side surface, and a second surface that is opposite the first surface, an emitter region positioned at the first surface of the semiconductor substrate and doped with impurities of a second conductive type opposite the first conductive type, a back surface field region positioned at the second surface of the semiconductor substrate and more heavily doped than the semiconductor substrate with the impurities of the first conductive type, a first electrode connected to the emitter region, and a second electrode connected to the back surface field region, wherein the emitter region is further positioned at a side surface of the semiconductor substrate and is positioned at an edge portion of the second surface of the semiconductor substrate, and wherein the back surface field region is separated from the emitter region positioned at the edge portion of the second surface of the semiconductor substrate.

A depth of the emitter region positioned at the side surface of the semiconductor substrate may be less than a depth of the emitter region positioned at the first surface of the semiconductor.

For example, the depth of the emitter region positioned at the side surface of the semiconductor substrate may be 1 nm to 10 nm, and the depth of the emitter region positioned at the first surface of the semiconductor may be 0.2 µm to 2 µm.

The solar cell may further include a back passivation layer on the back surface field region positioned at the second surface of the semiconductor substrate. The back passivation layer may further cover the semiconductor substrate exposed at a separation portion between the back surface field region and the emitter region at the edge portion of the second surface of the semiconductor substrate.

The back surface field region may be separated from the emitter region by the separation portion, a depth of the emitter region positioned at the side surface of the semiconductor substrate may be less than a width of the edge portion, and the back surface field region may be positioned on the entire second surface of the semiconductor substrate except the edge portion.

In another aspect, there is provided a method for manufacturing a solar cell including: injecting impurities of a second conductive type opposite a first conductive type into an entire first surface of a semiconductor substrate containing impurities of the first conductive type, the semiconductor substrate having the first surface, a side surface, and a second surface opposite the first surface; forming a doping barrier layer on the entire first surface and an entire side surface of the semiconductor substrate, and at an edge portion of the second surface of the semiconductor substrate; injecting the impurities of the first conductive type into a portion of the second surface of the semiconductor substrate at which the doping barrier layer is not formed, at a higher concentration than the semiconductor substrate, so that the edge portion of the second surface remains undoped by the impurities of the first conductive type; performing a thermal process on the semiconductor substrate to simultaneously form an emitter region of the second conductive type at the entire first and side surfaces of the semiconductor substrate and a back surface field region of the first conductive type at the second surface of the semiconductor substrate; and removing the doping barrier layer.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 illustrates an example of a solar cell manufactured based on a manufacturing method according to an example embodiment of the invention; and
FIGS. 2 to 7 illustrate an example of a method for manufacturing a solar cell according to an example embodiment of the invention.

### DETAILED DESCRIPTION OF THE EMBODIMENTS

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers will be used throughout the drawings to refer to the same or like parts. It will be noted that a detailed description of known arts will be omitted if it is determined that the detailed description of the known arts can obscure the embodiments of the invention.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

In the following description, "front surface" may be one surface of a semiconductor substrate, on which light is directly incident, and "back surface" may be a surface opposite the one surface of the semiconductor substrate, on which light is not directly incident or reflective light may be incident.

In the following description, the fact that any two values are substantially equal to each other means that the two values are equal to each other within a margin of error of 10 % or less.

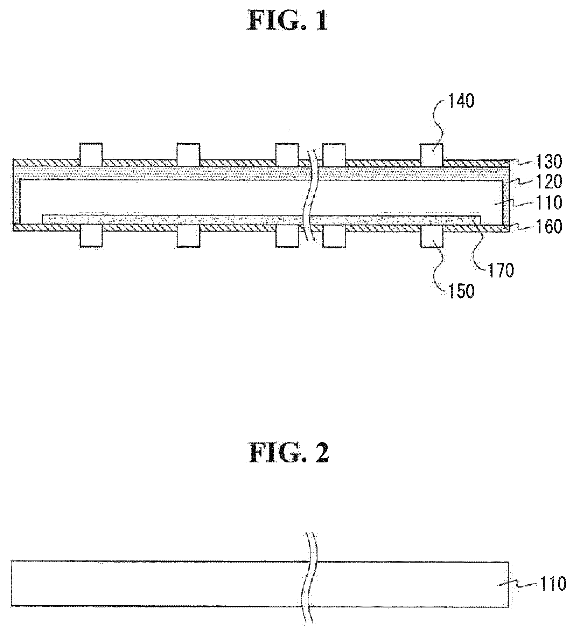

A solar cell according to an example embodiment of the invention is described with reference to FIGS. 1 to 7.

FIG. 1 illustrates an example of a solar cell manufactured based on a manufacturing method according to an example embodiment of the invention.

As shown in FIG. 1, a solar cell according to an example embodiment of the invention may include a semiconductor substrate 110, an emitter region 120, an anti-reflection layer 130, a plurality of first electrodes 140, a back surface field region 170, a back passivation layer 160, and a plurality of second electrodes 150.

The semiconductor substrate 110 may have a first conductive type, for example, an n-type or a p-type. The semiconductor substrate 110 may be formed of one of single crystal silicon, polycrystalline silicon, and amorphous silicon. For example, the semiconductor substrate 110 may be formed of a crystalline silicon wafer.

More specifically, when the semiconductor substrate 110 is of the p-type, the semiconductor substrate 110 may be doped with impurities of a group III element such as boron (B), gallium (Ga), and indium (In). Alternatively, the semiconductor substrate 110 may be of the n-type. Namely, when the semiconductor substrate 110 is of the n-type, the semiconductor substrate 110 may be doped with impurities of a group V element, such as phosphorus (P), arsenic (As), and antimony (Sb).

A front surface (or a first surface) of the semiconductor substrate 110 may be textured to form a textured surface corresponding to an uneven surface having a plurality of uneven portions or having uneven characteristics. FIG. 1 shows that only an edge of the semiconductor substrate 110 has the textured surface for the sake of brevity and ease of reading. However, the entire front surface of the semiconductor substrate 110 substantially has the textured surface, and thus the emitter region 120 and the anti-reflection layer 130 positioned on the front surface of the semiconductor substrate 110 may have a textured surface.

As shown in FIG. 1, the emitter region 120 may be entirely formed at one surface and a side surface of the semiconductor substrate 110. In the following description, for example, one surface of the semiconductor substrate 110 is the front surface of the semiconductor substrate 110, and other surface (opposite surface or second surface) of the semiconductor substrate 110 is a back surface of the semiconductor substrate 110.

The emitter region 120 may be formed at an entire incident surface (i.e., the entire front surface) and the entire side surface of the semiconductor substrate 110. More specifically, the emitter region 120 formed at the side surface of the semiconductor substrate 110 may be extended to the back surface of the semiconductor substrate 110 and may be formed at an edge or an edge portion of the back surface of the semiconductor substrate 110.

In the embodiment disclosed herein, a depth of the emitter region 120 positioned at the side surface of the semiconductor substrate 110 may be less than a depth of the emitter region 120 positioned at the front surface of the semiconductor substrate 110. For example, the depth of the emitter region 120 positioned at the side surface of the semiconductor substrate 110 may be 1 nm to 10 nm, and the depth of the emitter region 120 positioned at the front surface of the semiconductor substrate 110 may be 0.2 µm to 2 µm.

Hence, the embodiment of the invention may cause an amount of carriers moving to the emitter region 120 positioned at the front surface of the semiconductor substrate 110 to be sufficiently more than an amount of carriers moving to the emitter region 120 positioned at the side surface of the semiconductor substrate 110 and may also minimize an amount of carriers moving to the emitter region 120 positioned at the side surface of the semiconductor substrate 110. The emitter region 120 may be a region formed by doping the semiconductor substrate 110 with impurities of a second conductive type (for example, n-type) opposite the first conductive type (for example, p-type). Thus, the emitter region 120 of the second conductive type may form a p-n junction along with a first conductive type region of the semiconductor substrate 110.

Carriers, for example, electron-hole pairs produced by light incident on the semiconductor substrate 110 may be separated into electrons and holes. The separated electrons may move to the n-type semiconductor, and the separated holes may move to the p-type semiconductor. Thus, when the semiconductor substrate 110 is of the p-type and the emitter region 120 is of the n-type, the separated electrons may move to the emitter region 120, and the separated holes may move to the back surface of the semiconductor substrate 110.

Because the emitter region 120 forms the p-n junction along with the semiconductor substrate 110 (i.e., the first conductive type region of the semiconductor substrate 110), the emitter region 120 may be of the p-type if the semiconductor substrate 110 is of the n-type unlike the embodiment described above. In this instance, the separated electrons may move to the back surface of the semiconductor substrate 110, and the separated holes may move to the emitter region 120.

Returning to the embodiment of the invention, when the emitter region 120 is of the n-type, the emitter region 120 may be formed by doping the semiconductor substrate 110 with impurities of a group V element such as P, As, and Sb. On the contrary, when the emitter region 120 is of the p-type, the emitter region 120 may be formed by doping the semiconductor substrate 110 with impurities of a group III element such as B, Ga, and In.

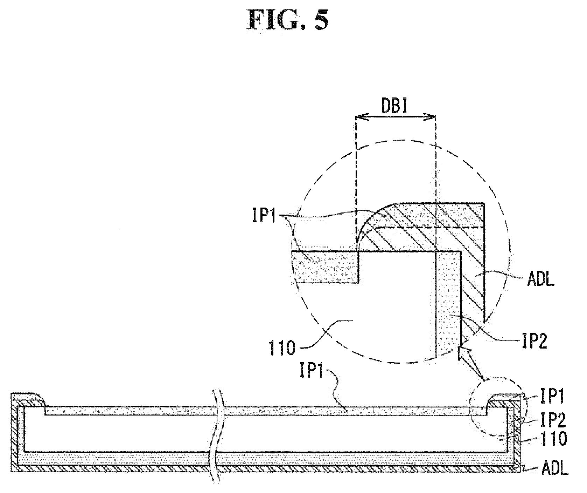

The anti-reflection layer 130 may be positioned on the incident surface of the semiconductor substrate 110. As shown in FIGS. 1 and 5, when the emitter region 120 is positioned on the incident surface of the semiconductor substrate 110, the anti-reflection layer 130 may be positioned on the emitter region 120.

The anti-reflection layer 130 may be formed as a plurality of layers using at least one of hydrogenated silicon nitride (SiNx:H), hydrogenated silicon oxide (SiOx:H), hydrogenated silicon nitride oxide (SiNxOy:H), or hydrogenated amorphous silicon (a-Si:H).

The anti-reflection layer 130 thus formed can further enhance a passivation function and further improve a photoelectric efficiency of the solar cell.

As shown in FIG. 1, the plurality of first electrodes 140 may be separated from one another on the front surface of the semiconductor substrate 110 and extended in a first direction x.

In this instance, the plurality of first electrodes 140 may pass through the anti-reflection layer 130 and may be electrically connected to the emitter region 120.

Hence, the plurality of first electrodes 140 may be formed of at least one conductive material, for example, silver (Ag) and may collect carriers (for example, electrons) moving to the emitter region 120.

The back surface field region 170 may be positioned on the opposite surface (i.e., the back surface) of the semiconductor substrate 110. The back surface field region 170 may be a region (for example, a p⁺-type region) which is more heavily doped than the semiconductor substrate 110 with impurities of the same first conductive type as the semiconductor substrate 110.

A potential barrier is formed by a difference between impurity concentrations of the first conductive type region of the semiconductor substrate 110 and the back surface field region 170. Hence, the potential barrier can prevent or reduce electrons from moving to the back surface field region 170 used as a moving path of holes and can make it easier for holes to move to the back surface field region 170.

Thus, the embodiment of the invention can reduce an amount of carriers lost by a recombination and/or a disappearance of electrons and holes at and around the back surface of the semiconductor substrate 110 and can accelerate a movement of desired carriers (for example, holes), thereby increasing an amount of carriers moving to the second electrodes 150.

The back surface field region 170 may be entirely formed in a remaining area excluding a formation area of the second electrodes 150 from the back surface of the semiconductor substrate 110. The back surface field region 170 may be positioned to be separated from the emitter region 120 at the edge of the back surface of the semiconductor substrate 110.

The solar cell according to the embodiment of the invention may be configured such that the back surface field region 170 and the emitter region 120 are separated from each other at the edge of the back surface of the semiconductor substrate 110, thereby preventing a reverse current that carriers moving to the back surface field region 170 and carriers moving to the emitter region 120 are recombined and disappeared.

The back passivation layer 160 may be formed while entirely covering a remaining area excluding a formation area of the second electrodes 150 from the back surface of the semiconductor substrate 110. The back passivation layer 160 may perform a passivation function and an insulation function with respect to the back surface of the semiconductor substrate 110. The back passivation layer 160 may be formed as at least one layer using at least one of silicon nitride (SiNx), silicon oxide (SiOx), or silicon nitride oxide (SiNxOy).

As shown in FIG. 1, the back passivation layer 160 may be formed to cover the semiconductor substrate 110 exposed to a separation portion between the back surface field region 170 and the emitter region 120 at the edge of the opposite surface of the semiconductor substrate 110 when viewed from the back surface of the solar cell.

The second electrodes 150 may be separated from one another on the opposite surface (i.e., the back surface) of the semiconductor substrate 110 and extended.

The second electrodes 150 may overlap the back surface field region 170 and may be electrically connected to the back surface field region 170. The second electrodes 150 may receive carriers (for example, holes) from the back surface field region 170.

Because the second electrodes 150 contact the back surface field region 170 that is maintained at a higher impurity concentration than the semiconductor substrate 110, a contact resistance between the back surface field region 170 and the second electrodes 150 decreases. Hence, a transfer efficiency of carriers from the semiconductor substrate 110 to the second electrodes 150 may be improved.

An interconnector is connected to the second electrodes 150, and carriers (for example, holes) collected by the second electrodes 150 may be transferred to another solar cell adjacent to the above-described solar cell through the interconnector.

The second electrodes 150 may include a metal material with good conductivity. For example, the second electrodes 150 may contain at least one conductive material such as silver (Ag).

In order to form the above-described solar cell, a method for forming the emitter region 120 and the back surface field region 170 according to the embodiment of the invention is described below.

FIGS. 2 to 7 illustrate an example of a method for manufacturing a solar cell according to an example embodiment of the invention.

An example of a method for manufacturing the solar cell according to the embodiment of the invention may include injecting impurities IP2 of a second conductive type, forming a doping barrier layer ADL, injecting impurities IP1 of a first conductive type, performing a thermal process, and performing a cleansing process, in order to form the emitter region 120 and the back surface field region 170 illustrated in FIG. 1.

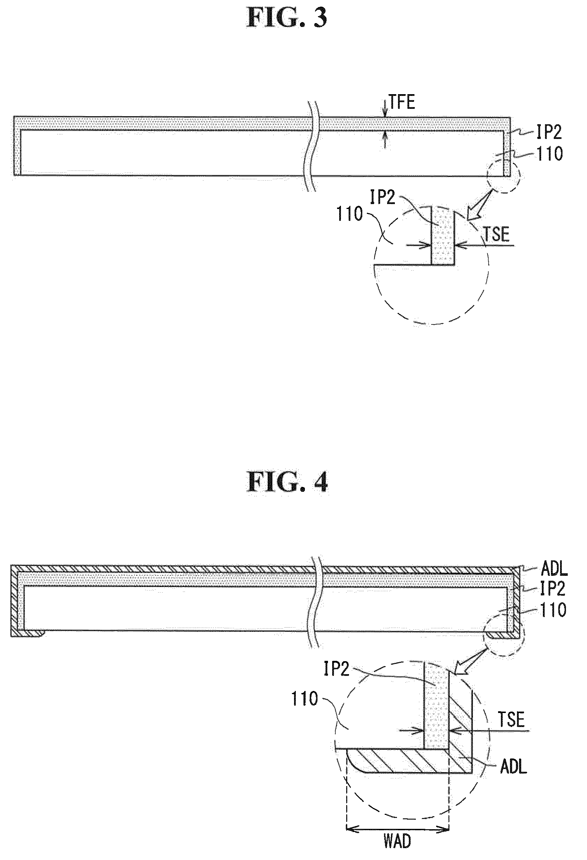

In order to form the emitter region 120, as shown in FIG. 3, the impurities IP2 of the second conductive type may be injected into the entire front surface of the semiconductor substrate 110 shown in FIG. 2. In this instance, the semiconductor substrate 110 may be, for example, a wafer containing impurities of the first conductive type.

More specifically, when the first conductive type of the semiconductor substrate 110 is an n-type, the emitter region 120 may be formed by injecting boron (B) used as an example of the second conductive type impurities IP2 into the entire front surface of the semiconductor substrate 110.

As a method for injecting boron (B), an ion implantation method may be used.

When the ion implantation method is used in the process for injecting the second conductive type impurities IP2 as described above, the second conductive type impurities IP2, as shown in FIG. 3, may be injected into an edge of the back surface of the semiconductor substrate 110 as well as the side surface of the semiconductor substrate 110 and the entire front surface of the semiconductor substrate 110.

In the above-described process for injecting the second conductive type impurities IP2, a depth TSE of the second conductive type impurities IP2 injected into the side surface of the semiconductor substrate 110 may be less than a depth TFE of the second conductive type impurities IP2 injected into the front surface of the semiconductor substrate 110.

For example, the depth TSE of the second conductive type impurities IP2 injected into the front surface of the semiconductor substrate 110 may be 0.2 µm to 2 µm, and the depth TSE of the second conductive type impurities IP2 injected into the side surface of the semiconductor substrate 110 may be 1 nm to 10 nm.

When a subsequent process for injecting the impurities IP1 of the first conductive type into the back surface of the semiconductor substrate 110 to form the back surface field region 170 is performed in a state where the second conductive type impurities IP2 is injected into the side surface of the semiconductor substrate 110 reaching the edge of the back surface of the semiconductor substrate 110 as well as the front surface of the semiconductor substrate 110, the back surface field region 170 and the emitter region 120 may contact each other at the edge of the back surface of the semiconductor substrate 110. Hence, the reverse current may be generated.

In this instance, the reverse current may result in a reduction in the efficiency of the solar cell. In order to prevent the reverse current, the embodiment of the invention may further include forming the doping barrier layer ADL after injecting the second conductive type impurities IP2 and before injecting the first conductive type impurities IP1.

As shown in FIG. 4, the doping barrier layer ADL may be formed on the entire front surface and the entire side surface of the semiconductor substrate 110 and at the edge of the back surface of the semiconductor substrate 110.

A material of the doping barrier layer ADL may be silicate glass that is not doped with impurities of the first and second conductive types and contains silica (SiO₂).

The embodiment of the invention is described using silicate glass containing silica (SiO₂) as an example of the doping barrier layer ADL. Other materials may be used for the doping barrier layer ADL. For example, any material may be used for the doping barrier layer ADL according to the embodiment of the invention as long as the material has a characteristic capable of blocking the impurity doping.

For example, the doping barrier layer ADL may use silicon nitride (SiNx) instead of silicate glass containing silica (SiO₂).

The doping barrier layer ADL may be formed using at least one of a thermal oxidation method, a chemical vapor deposition (CVD) method, an electrochemical oxidation method or anodization method.

The doping barrier layer ADL may prevent out-diffusion, in which the second conductive type impurities IP2 injected into the semiconductor substrate 110 get out of the semiconductor substrate 110 in the subsequent thermal process. Further, the doping barrier layer ADL may prevent the first conductive type impurities IP1 from being injected into the edge of the back surface of the semiconductor substrate 110 in the process for injecting the first conductive type impurities IP1.

In the process for forming the doping barrier layer ADL, the doping barrier layer ADL formed at the edge of the back surface of the semiconductor substrate 110 may be formed to cover the edge of the back surface of the semiconductor substrate 110, to which the second conductive type impurities IP2 injected into the side surface of the semiconductor substrate 110 are exposed, as indicated by an enlarged portion of FIG. 4.

A method for forming the doping barrier layer ADL on the front surface and the side surface of the semiconductor substrate 110 and at the edge of the back surface of the semiconductor substrate 110 is described below.

When the doping barrier layer ADL is formed on the front surface of the semiconductor substrate 110, the doping barrier layer ADL may be formed on the front surface and the side surface of the semiconductor substrate 110 due to a deposition characteristic. Further, when the doping barrier layer ADL is deposited, the edge of the semiconductor substrate 110 may be lifted. Hence, the doping barrier layer ADL may be formed at the lifted edge of the back surface of the semiconductor substrate 110. In this instance, a lifting height of the semiconductor substrate 110 may be adjusted by controlling a deposition temperature when the doping barrier layer ADL is deposited.

As described above, the doping barrier layer ADL is formed to cover the edge of the back surface of the semiconductor substrate 110. Therefore, when the first conductive type impurities IP1 are injected into the back surface of the semiconductor substrate 110, the doping barrier layer ADL may prevent an injection area of the first conductive type impurities IP1 and an injection area of the second conductive type impurities IP2 from directly contacting each other at the edge of the back surface of the semiconductor substrate 110.

To this end, more preferably, a width WAD of the doping barrier layer ADL formed at the edge of the back surface of the semiconductor substrate 110 may be greater than a width TSE of a portion where the second conductive type impurities IP2 is doped and exposed to the edge of the back surface of the semiconductor substrate 110.

For example, the width WAD of the doping barrier layer ADL formed at the edge of the back surface of the semiconductor substrate 110 may be greater than the width TSE of the second conductive type impurities IP2 exposed to the edge of the back surface of the semiconductor substrate 110 and may be equal to or less than 5 mm.

The width TSE of the second conductive type impurities IP2 exposed to the edge of the back surface of the semiconductor substrate 110 may be substantially equal to a width TSE of the second conductive type impurities IP2 injected into the side surface of the semiconductor substrate 110 and may be 1 nm to 10 nm.

Afterwards, as shown in FIG. 5, the process for injecting the first conductive type impurities IP1 may include turning the semiconductor substrate 110 upside down so that the back surface of the semiconductor substrate 110 upwardly faces in a state where the doping barrier layer ADL is formed, and then injecting phosphorus (P) used as an example of the first conductive type impurities IP1 into the back surface of the semiconductor substrate 110 at a higher concentration than the semiconductor substrate 110.

The ion implantation method may be used in the process for injecting the first conductive type impurities IP1.

As shown in FIG. 5, in the process for injecting the first conductive type impurities IP1, the first conductive type impurities IP1 may be injected into the entire back surface of the semiconductor substrate 110 except the edge of the back surface of the semiconductor substrate 110.

However, in the process for injecting the first conductive type impurities IP1, the first conductive type impurities IP1 may be injected while being spaced apart from the edge of the back surface of the semiconductor substrate 110, into which the second conductive type impurities IP2 are injected, by a predetermined width DBI due to the doping barrier layer ADL formed at the edge of the back surface of the semiconductor substrate 110.

In this instance, as shown in an enlarged portion of FIG. 5, a portion of the second conductive type impurities IP2 may be injected into the surface of the doping barrier layer ADL formed at the edge of the back surface of the semiconductor substrate 110.

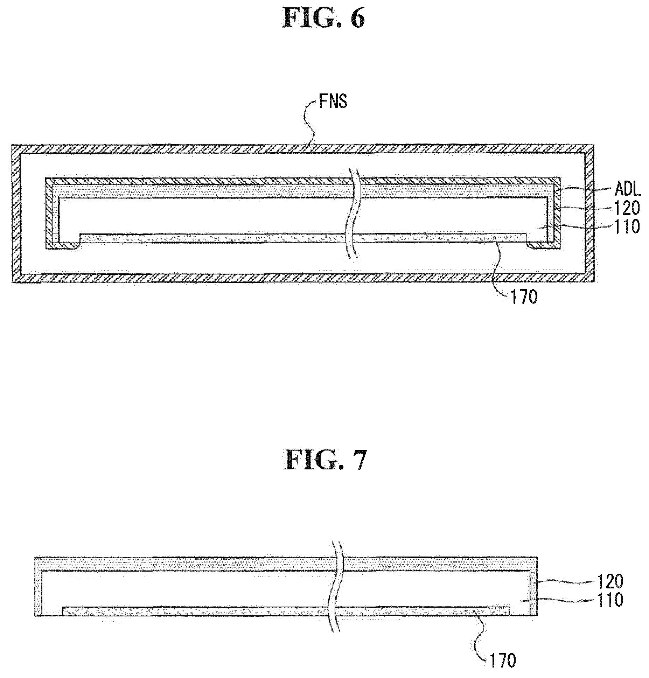

As shown in FIG. 6, after the processes for injecting the impurities IP1 and IP2 of the first and second conductive types are completed, the thermal process may be performed on the semiconductor substrate 110 in a state where the semiconductor substrate 110 is positioned in a diffusion furnace FNS to simultaneously form the emitter region 120 of the second conductive type and the back surface field region 170 of the first conductive type at the semiconductor substrate 110.

More specifically, the impurities IP1 and IP2 of the first and second conductive types injected into the semiconductor substrate 110 may be simultaneously activated through the thermal process.

The thermal process to form the emitter region 120 and the back surface field region 170 by activating the impurities IP1 and IP2 of the first and second conductive types may be performed at 950 °C to 1,050 °C for 30 to 40 minutes.

The emitter region 120 and the back surface field region 170 formed through the thermal process may be separated from each other at the edge of the back surface of the semiconductor substrate 110.

Afterwards, in the cleansing process, the doping barrier layer ADL formed on the front surface and the side surface of the semiconductor substrate 110 and at the edge of the back surface of the semiconductor substrate 110 may be removed.

As a cleansing solution used in the cleansing process, diluted HF (DHF) obtained by diluting hydrogen fluoride (HF) in deionized water (DI) may be used. For example, diluted HF may be diluted under the condition that a ratio of deionized water (DI) to HF is 15:2. The semiconductor substrate 110 may be soaked in diluted HF for 5 to 10 minutes, and thus the doping barrier layer ADL may be removed from the semiconductor substrate 110.

Afterwards, the anti-reflection layer 130 and the first electrodes 140 may be formed on the front surface of the semiconductor substrate 110, and the back passivation layer 160 and the second electrodes 150 may be formed on the back surface of the semiconductor substrate 110, thereby manufacturing the solar cell shown in FIG. 1.

As described above, the method for manufacturing the solar cell according to the embodiment of the invention includes forming the doping barrier layer ADL after injecting the second conductive type impurities IP2 into one surface of the semiconductor substrate 110 and before injecting the first conductive type impurities IP1 into the opposite surface of the semiconductor substrate 110, and thus can form the emitter region 120 and the back surface field region 170 to be naturally separated from each other. Hence, the efficiency of the solar cell can be further improved.

As shown in FIGS. 2 to 7, the method for manufacturing the solar cell according to the embodiment of the invention was described using an example where the emitter region 120 is formed on the front surface of the semiconductor substrate 110 and the back surface field region 170 is formed on the back surface of the semiconductor substrate 110. However, the embodiment of the invention is not limited thereto. For example, the embodiment of the invention may be equally applied to an example where the emitter region 120 is formed on the back surface of the semiconductor substrate 110 and the back surface field region 170 is formed on the front surface of the semiconductor substrate 110.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A method for manufacturing a solar cell comprising:
injecting impurities of a second conductive type opposite a first conductive type into an entire first surface of a semiconductor substrate containing impurities of the first conductive type, the semiconductor substrate having the first surface, a side surface, and a second surface opposite the first surface;
forming a doping barrier layer on the entire first surface and the entire side surface of the semiconductor substrate, and at an edge portion of the second surface of the semiconductor substrate;
injecting the impurities of the first conductive type into a portion of the second surface of the semiconductor substrate at which the doping barrier layer is not formed, at a higher concentration than the semiconductor substrate;
performing a thermal process on the semiconductor substrate to simultaneously form an emitter region of the second conductive type at the entire first and side surfaces of the semiconductor substrate and a back surface field region of the first conductive type at the second surface of the semiconductor substrate; and
removing the doping barrier layer.

2. The method of claim 1, wherein the impurities of the first conductive type and the impurities of the second conductive type injected into the semiconductor substrate are simultaneously activated through the thermal process.

3. The method of claim 1, wherein the injecting of the impurities of the second conductive type includes injecting the impurities of the second conductive type into the side surface of the semiconductor substrate reaching the edge portion of the second surface of the semiconductor substrate.

4. The method of claim 3, wherein in the injecting of the impurities of the second conductive type, a depth of the impurities of the second conductive type injected into the side surface of the semiconductor substrate is less than a depth of the impurities of the second conductive type injected into the first surface of the semiconductor substrate.

5. The method of claim 3, wherein in the forming of the doping barrier layer, the doping barrier layer formed at the edge portion of the second surface of the semiconductor substrate covers the edge portion of the second surface of the semiconductor substrate, to cover the impurities of the second conductive type injected into the side surface of the semiconductor substrate.

6. The method of claim 5, wherein a width of the doping barrier layer formed at the edge portion of the second surface of the semiconductor substrate is greater than a width of the impurities of the second conductive type exposed in the edge portion of the second surface of the semiconductor substrate.

7. The method of claim 1, wherein the doping barrier layer is not doped with the impurities of the first conductive type and the impurities of the second conductive type.

8. The method of claim 7, wherein the doping barrier layer is formed of silicate glass containing silica (SiO₂).

9. The method of claim 1, wherein the injecting of the impurities of the first conductive type includes injecting the impurities of the first conductive type into the entire portion of the semiconductor substrate except the edge portion of the second surface of the semiconductor substrate.

10. The method of claim 7, wherein the injecting of the impurities of the first conductive type includes injecting the impurities of the first conductive type while being separated from the edge portion of the second surface of the semiconductor substrate including the impurities of the second conductive type.

11. The method of claim 1, wherein the performing of the thermal process includes forming the emitter region and the back surface field region while the impurities of the first conductive type and the impurities of the second conductive type are separated from each other at the edge portion of the second surface of the semiconductor substrate.

12. A solar cell comprising:
a semiconductor substrate containing impurities of a first conductive type, the semiconductor substrate having a first surface, a side surface, and a second surface that is opposite the first surface;
an emitter region positioned at the first surface of the semiconductor substrate and doped with impurities of a second conductive type opposite the first conductive type;
a back surface field region positioned at the second surface of the semiconductor substrate and more heavily doped than the semiconductor substrate with the impurities of the first conductive type;
a first electrode connected to the emitter region; and
a second electrode connected to the back surface field region,
wherein the emitter region is further positioned at a side surface of the semiconductor substrate and is positioned at an edge portion of the second surface of the semiconductor substrate, and
wherein the back surface field region is separated from the emitter region positioned at the edge portion of the second surface of the semiconductor substrate.

13. The solar cell of claim 12, wherein a depth of the emitter region positioned at the side surface of the semiconductor substrate is less than a depth of the emitter region positioned at the first surface of the semiconductor,.
wherein the depth of the emitter region positioned at the side surface of the semiconductor substrate is 1 nm to 10 nm, and
wherein the depth of the emitter region positioned at the first surface of the semiconductor is 0.2 µm to 2 µm.

14. The solar cell of claim 12, further comprising a back passivation layer on the back surface field region positioned at the second surface of the semiconductor substrate,
wherein the back passivation layer further covers the semiconductor substrate exposed at a separation portion between the back surface field region and the emitter region at the edge portion of the second surface of the semiconductor substrate, and
wherein the back surface field region is separated from the emitter region by the separation portion.

15. The solar cell of claim 12, wherein a depth of the emitter region positioned at the side surface of the semiconductor substrate is less than a width of the edge portion.
